# FASCICULE DE BREVET EUROPEEN

(11) **EP 2 704 200 B1**
(45) Date de publication et mention de la délivrance du brevet: **03.05.2017**
(21) Numéro de dépôt: 13194957.0
(22) Date de dépôt: 11.02.2009
(51) Int. Cl.: H01L 29/792, H01L 27/12, H01L 21/84

(54) **Procédé d'ajustement de la tension de seuil d'un transistor par des couches de piégeage enterrées**
Verfahren zur Justierung der Schwellenspannung eines Transistors durch vergrabenen Fallenschichte.
Method of adjusting the threshold voltage of a transistor by buried trapping layers.

(30) Priorité: 19.02.2008 FR 0851073
(43) Date de publication de la demande: 05.03.2014
(62) Demande divisionnaire de: 09711545.5
(73) Titulaire: Commissariat à l'Énergie Atomique et aux Énergies Alternatives, 75015 Paris (FR)
(72) Inventeur: Andrieu, François, 38330 SAINT ISMIER (FR); Augendre, Emmanuel, 38330 MONTBONNOT (FR); Clavelier, Laurent, 38000 GRENOBLE (FR); Kostrzewa, Marek, 85662 HOHENBRUNN (DE)
(74) Mandataire: GIE Innovation Competence Group

(56) Documents cités:
- US-A1- 2005 067 659
- US-A1- 2007 267 679
- US-B2- 7 057 234
- ARVIND KUMAR ET AL: "Scaling of Flash NVRAM to 10's of nm by Decoupling of Storage From Read/Sense Using Back-Floating Gates", IEEE TRANSACTIONS ON NANOTECHNOLOGY, IEEE SERVICE CENTER, PISCATAWAY, NJ, US, vol. 1, no. 4, 1 décembre 2002 (2002-12-01), XP011077084, ISSN: 1536-125X

## Description

La présente invention concerne un sous-ensemble électronique et un procédé pour le réaliser. Elle s'applique, en particulier, à l'ajustement de la tension de seuil d'un transistor MOS (acronyme de Metal-Oxide Semi-conductor pour semi-conducteur métal-oxyde) par une couche de piégeage enterrée.

La tension de seuil est un paramètre déterminant d'un transistor MOS. Généralement, dans un circuit, des transistors avec différentes tensions de seuil sont nécessaires parce que les transistors n'ont pas tous les mêmes fonctions et doivent avoir des performances différentes. Par exemple, certains transistors d'un circuit ont une tension de seuil élevée et donc un courant à l'état «bloqué» faible (transistors a faible consommation) alors que d'autres ont une tension de seuil faible et donc un courant à l'état «passant» élevé (transistors à haute performance). Différentes familles de transistors sont donc utilisées en conception de circuit. On réalise ces transistors sur silicium (Si) massif ou sur silicium sur isolant (ou « SOI », acronyme de Silicon on insulator) ou sur SON (« Silicium on Nothing » ou silicium sur rien), comme décrit dans l'article « Silicon-on-Nothing MOSFETs : Performance, Short-Channel Effects, and Backgate Coupling » de Jérémy Pretet et autres, IEEE Transactions on Electron Devices, Vol. 51, No. 2, février 2004.

La tension de seuil dépendant généralement du dopage du canal, différentes implantations du canal du transistor sont généralement utilisées. Une autre technique, dite « fully depleted », ou « FD », permet de réaliser des transistors sur films non dopés. Cette technique peut être mise en oeuvre sur SOI, comme décrit dans l'article « Threshold Voltage of Thin-Film Silicon-on-Insulator (SOI) MOSFET's » de Kyung-Kyu LIM et autres, IEEE Transactions on Electron Devices, Vol. ED-30, No. 10, Octobre 1983. On parle alors de « FDSOI » (acronyme de « fully depleted SOI »), ou sur SON. Cette technique permet d'assurer un meilleur contrôle électrostatique, une diminution de la variabilité et une augmentation de la mobilité. Dans ce cas, la tension de seuil est essentiellement dépendante du travail de sortie de la grille du transistor (et peu du dopage).

Ainsi, pour obtenir différentes tensions de seuil dans cette architecture, une solution consiste à co-intégrer des grilles avec des travaux de sortie différents. Cette approche présente de nombreux inconvénients. En effet, l'ajustement du travail de sortie des grilles et la co-intégration restent de véritables défis technologiques et physiques. Aussi, d'une façon générale, l'ajustement de la tension de seuil sur des dispositifs FD reste un défi majeur et bloquant.

On connaît, du document EP 0 409 697, un transistor MOS à tension de seuil ajustable. Dans ce document, un transistor à grille flottante présente une tension de seuil ajustée de façon continue par piégeage. Par rapport à la structure usuelle à grille flottante, l'oxyde tunnel est, dans ce document, aminci au-dessus du drain pour faciliter la programmation. Cependant, dans ce cas, l'empilement de grille doit à la fois être compatible avec l'application mémoire et l'application logique, ce qui est difficilement réalisable. En effet, en logique, on a intérêt à augmenter le couplage grille/canal (en diminuant l'épaisseur de l'oxyde de grille) alors qu'en mémoire, une taille minimale d'oxyde tunnel doit être maintenue pour garantir une bonne rétention. L'oxyde est donc nécessairement épais, ce qui n'est pas optimum pour les transistors logiques.

On connaît aussi le document de H. Silva et S. Tiwari "A Nanoscale Memory and Transistor Using Backside Trapping", IEEE Trans. on Nanotechnology vol. 3 N°12 Juin 2004. Dans ce document, la modulation de la tension de seuil du transistor est effectuée par piégeage dans l'isolant enterré et par couplage capacitif. La modulation de la tension de seuil se fait toujours dans les mêmes conditions (binaires). Les courbes montrées dans ce document sont typiques de l'application mémoire, en termes d'endurance et de durée de rétention.

Le brevet correspondant, US 7,057,234 concerne la structure : des nano-cristaux de silicium sont mentionnés comme sites de piégeage possibles. Ce document indique l'utilisation de cette structure soit pour des transistors en mode logique soit pour des points mémoire, modes différenciés par les jeux de polarisation distincts. Ce document propose d'utiliser le mécanisme de piégeage pour les points mémoire uniquement.

Ce document ne concerne donc pas du tout la réalisation de transistors à tension de seuil ajustable, et notamment de transistors dont la tension de seuil est volontairement ajustée en fonction de l'application visée pour ce transistor (transistor à basse tension de seuil, à tension de seuil standard ou à haute tension de seuil), pour les applications logiques ou analogiques.

Il n'existe donc, aujourd'hui, aucune solution technologique qui permette de réaliser simultanément des transistors FD optimisés, notamment d'un point de vue électrostatique (et plus particulièrement pour les canaux courts) et dont la tension de seuil soit ajustable en fonction de l'application recherchée pour ce transistor (pour les applications logiques ou analogiques).

La présente invention vise à remédier à ces inconvénients.

A cet effet, selon un premier aspect, la présente invention vise un sous-ensemble électronique, conforme à la revendication 1.

La présente invention permet, du fait du couplage des pièges avec la grille, une application de transistor classique, dans laquelle c'est le transport de charges (c'est-à-dire le courant) qui est l'information, la tension étant un paramètre parmi d'autres de la caractéristique courant/tension du dispositif, au même titre que la mobilité des porteurs de charges, par exemple. De même, dans cette application, l'état de charge de structure n'est pas l'information principale. Ainsi, dans l'application « transistor » visée par la présente invention, l'information varie selon la fonction du transistor. En analogique ou radiofréquence (« RF »), toute une partie de la caractéristique courant/tension du transistor est utilisée et constitue l'information. Les dispositifs élémentaires ne sont pas nécessairement matricés mais répartis en blocs assurant une fonction particulière.

Parmi les avantages de la présente invention, on peut aussi citer :
- l'ajustement de la tension de seuil peut se faire par polarisation de la zone du substrat sous le transistor considéré (écriture en « Fowler Nordheim »),
- l'ajustement de la tension de seuil peut se faire transistor par transistor par combinaison d'une polarisation de substrat et d'une polarisation de drain (« écriture en porteurs chauds »). Dans ce cas, la prise substrat peut être partagée/mutualisée pour plusieurs transistors sans, pour autant, que cela leur affecte une certaine fonction par rapport à la valeur de la tension de seuil. Cet ajustement nécessite une prise, au moins, pour piloter la tension Vds aux bornes du transistor dont on veut ajuster la tension de seuil ou un pilotage indirecte de la tension Vds du transistor par l'intermédiaire des prises accessibles du circuit dans lequel se trouve le transistor,
- la tension de seuil peut être ajustée par l'écriture de plus ou moins de pièges enterrés, de façon quasi continue, alors que, dans le cas d'une utilisation de plusieurs travaux de sortie de grille ou de plusieurs dopages canal, seul un nombre discret d'état de tension de seuil est permis et
- la tension de seuil d'un transistor peut être reconfigurée par des polarisations (de drain et de substrat) après la fabrication des transistors. Dans le cas général de l'état de l'art, les tensions de seuil des transistors sont fixées (par le dopage canal et le travail de sortie de la grille) lors de la fabrication des transistors et ne sont pas reconfigurables par la suite et peuvent évoluer de façon incontrôlée, notamment en fonction de la température ou de l'irradiation.

Les deux derniers avantages cités ci-dessus permettent d'envisager les applications suivantes :
- allocation dynamique des paramètres de consommation/vitesse de blocs de circuiterie,
- compensation de variabilité de la tension de seuil à cause de fluctuations technologiques,
- compensation de la dérive de la tension de seuil due à un changement de température extérieure (et contrôle de la consommation),
- compensation de la dérive de la tension de seuil due à l'utilisation en milieu radiatif (et augmentation de la durée de vie des systèmes),
- circuits reconfigurables et
- réalisation de transistors MOS à tension de seuil variable.

On observe que, préférentiellement, l'information utile de chaque transistor est le transport des charges au sein de ce transistor et non, comme dans l'art antérieur, l'état de charge du transistor. On adapte ainsi la tension de seuil pour optimiser le fonctionnement du transistor en fonction de l'application du transistor, logique ou analogique.

Selon des caractéristiques particulières, la première zone de piégeage s'étend uniquement sous le canal dudit premier transistor.

Selon des caractéristiques particulières, le sous-ensemble électronique objet de la présente invention, tel que succinctement exposé ci-dessus comporte, en outre, une zone conductrice placée, par rapport à la couche d'isolant, de l'autre côté de la couche de semi-conducteur portant au moins un premier transistor.

Cette zone conductrice permet la commande de la tension de seuil de chaque transistor en regard de laquelle elle se trouve, cette tension de seuil étant modulée par la présence des pièges qui se trouvent en position intermédiaire entre le transistor et la zone conductrice.

Selon des caractéristiques particulières, la zone conductrice est un substrat électriquement conducteur.

Selon des caractéristiques particulières, ladite zone conductrice est constituée d'une zone d'un substrat se trouvant sous la couche d'isolant et comportant des dopants, par exemple implantés.

Selon des caractéristiques particulières, le sous-ensemble électronique objet de la présente invention, tel que succinctement exposé ci-dessus comporte au moins une deuxième zone de piégeage.

Selon des caractéristiques particulières, la deuxième zone de piégeage est à une deuxième profondeur différente de la première profondeur.

Selon des caractéristiques particulières, la deuxième zone de piégeage présente une répartition de densités de pièges différente de celle de la première zone de piégeage.

Selon des caractéristiques particulières, ladite deuxième zone de piégeage se trouve, au moins en partie, sous un canal d'un deuxième transistor.

Selon des caractéristiques particulières, les dits pièges sont constitués de nano-cristaux.

Selon des caractéristiques particulières, lesdits nano-cristaux comportent des atomes de Si, de Ge, de métal ou d'alliage semiconducteur/métal dans une couche d'isolant.

Selon des caractéristiques particulières, les dits pièges sont formés par implantation d'atomes de N ou F et traitement thermique.

Selon des caractéristiques particulières, la couche d'isolant est formée d'un empilement de deux couches d'oxyde, une couche continue de piégeage étant formée à l'interface des deux couches d'oxyde.

Selon des caractéristiques particulières, la couche d'isolant est formée d'un empilement d'une couche d'oxyde, d'une couche continue de piégeage en nitrure ou polysilicium et d'une couche d'oxyde.

Dans ce cas, la couche d'oxyde supérieure sert à l'injection des charges par effet tunnel dans la couche de piégeage, la couche de piégeage sert à stocker des charges dans des pièges et la couche d'oxyde inférieure sert à assurer un couplage entre la couche de piégeage et un substrat ou la couche conductrice.

Selon un deuxième aspect, la présente invention vise un procédé de réalisation d'un sous-ensemble électronique conforme à la revendication 7.

Selon des caractéristiques particulières, au cours de l'étape de formation de la première zone de piégeage, on procède à une première implantation d'atomes de Ge, Si, métal ou alliage semiconducteur/métal dans la couche d'isolant.

Selon des caractéristiques particulières, au cours de l'étape de formation de la première zone de piégeage, on effectue un recuit, pour former des nano-cristaux.

Selon des caractéristiques particulières, le procédé objet de la présente invention, tel que succinctement exposé ci-dessus comporte une étape de formation d'une deuxième zone de piégeage s'étendant au moins sous un canal d'un deuxième transistor par une deuxième implantation avec une énergie et/ou une dose et/ou des atomes différents de ceux utilisés lors de la première implantation.

Selon des caractéristiques particulières, au cours de l'étape de formation de la première zone de piégeage, on applique un masquage pour positionner la première zone de piégeage.

Selon des caractéristiques particulières, au cours de l'étape de formation de la première zone de piégeage, on effectue un alignement grille directe, à travers l'empilement de grille, la grille de transistor étant utilisée comme masquage pour réaliser l'alignement de pièges sur le canal du transistor.

Selon des caractéristiques particulières, au cours de l'étape de formation de la première zone de piégeage, on effectue un alignement par approche grille damascène des transistors en vidant une cavité damascène d'au moins un transistor, en effectuant des implantations dans les cavités et en remplissant ensuite chaque cavité par un nouvel empilement de grilles.

Selon des caractéristiques particulières, le procédé objet de la présente invention, tel que succinctement exposé ci-dessus comporte une étape d'écriture en FN d'un transistor du sous-ensemble électronique.

Selon des caractéristiques particulières, le procédé objet de la présente invention, tel que succinctement exposé ci-dessus comporte une étape d'écriture en porteurs chauds d'un transistor du sous-ensemble électronique.

On observe qu'il est intéressant d'utiliser un oxyde enterré (ou un empilement d'oxyde enterré) fin ou à forte constante diélectrique pour diminuer la polarisation de substrat à appliquer pour charger les pièges de cet oxyde ou empilement d'oxyde. Des empilements permettant des effacements/écriture autour de 10 Volts ont été réalisés par les inventeurs pour des empilements enterrés de 5 nm d'oxyde tunnel / 70 nm de nitrure / 70 nm d'oxyde.

Selon des caractéristiques particulières, le procédé objet de la présente invention, tel que succinctement exposé ci-dessus comporte une étape de collage d'empilements de couches pour associer la couche de semi-conducteur, la couche d'isolant et une couche conductrice.

Les avantages, buts et caractéristiques particulières de ce procédé étant similaires à ceux sous-ensemble électronique objet de la présente invention, tel que succinctement exposé ci-dessus, ils ne sont pas rappelés ici.

D'autres avantages, buts et caractéristiques de la présente invention ressortiront de la description qui va suivre faite, dans un but explicatif et nullement limitatif, en regard des dessins annexés, dans lesquels :
- les figures 1 à 5 représentent différentes étapes de réalisation d'un premier mode de réalisation particulier du sous-ensemble électronique objet de la présente invention,
- la figure 6 représente, schématiquement, une étape alternative de réalisation du sous-ensemble électronique illustré en figure 5,
- les figures 7 à 9 représentent, schématiquement, des étapes de réalisation d'un deuxième mode de réalisation particulier du sous-ensemble électronique objet de la présente invention,
- les figures 10 à 12 représentent, schématiquement, des étapes de réalisation d'un troisième mode de réalisation particulier du sous-ensemble électronique objet de la présente invention,
- les figures 13 à 15 représentent, schématiquement, des étapes de réalisation d'un quatrième mode de réalisation particulier du sous-ensemble électronique objet de la présente invention,
- les figures 16 et 17 représentent, schématiquement, des étapes de réalisation d'un cinquième mode de réalisation particulier du sous-ensemble électronique objet de la présente invention et
- la figure 18 représente, en vue de dessus, une configuration permettant deux modes d'écriture d'un sous-ensemble électronique objet de la présente invention.

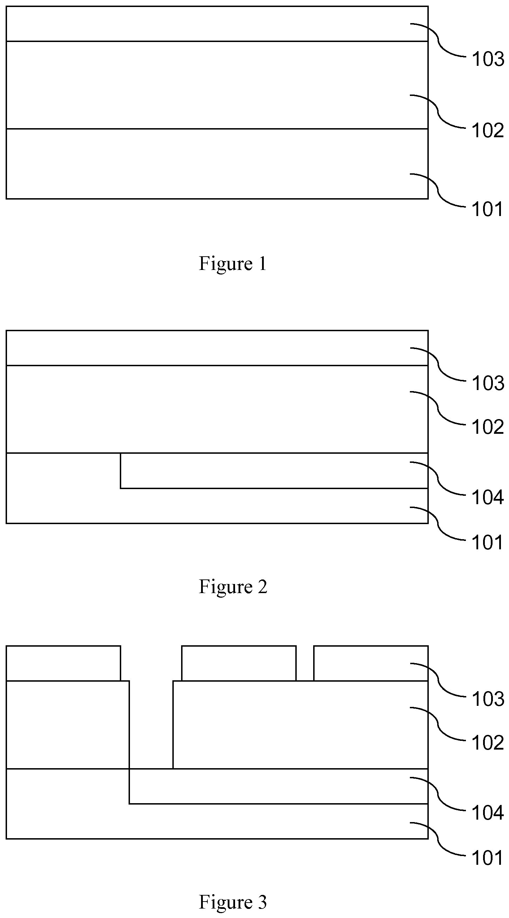

Comme on l'observe en figure 1, pour fabriquer le premier mode de réalisation du sous-ensemble électronique objet de la présente invention, on part d'un assemblage de couches comportant :
- un substrat 101,
- une couche d'isolant enterré 102 apte à piéger des charges sous l'effet d'un champ électrique, appelée « couche de piégeage »,
- un semi-conducteur supérieur, gravé ou non, 103.

La couche de piégeage 102 et la couche supérieure de semi-conducteur 103 sont en couplage capacitif pour permettre la réalisation dans la couche semi-conductrice, d'un transistor FD (« Fully depleted »).

Ensuite, comme illustré en figure 2, on réalise une couche conductrice 104, continue ou non, sous l'isolant enterré 102, par exemple par implantation de dopant dans le substrat 101 en utilisant un masquage. On observe que cette couche conductrice 104 peut être formée de façon analogue à une prise de caisson ou prise substrat dans le cas des transistors PDSOI (acronyme de « partially depleted SOI » pour SOI partiellement déserté). Cette couche conductrice 104 peut être omise si le substrat 101 est suffisamment conducteur lui-même pour jouer son rôle, comme expliqué plus loin.

Puis, comme illustré en figure 3, on effectue une gravure de la zone active du semi-conducteur supérieur 103.

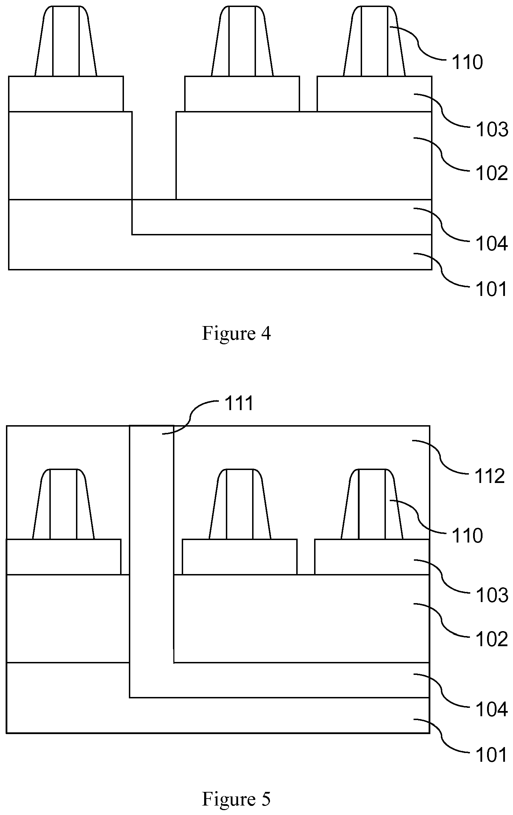

Comme illustré en figure 4, on réalise ensuite des transistors MOS 110 en surface de la couche semi-conductrice 103, de manière connue en soi. Au cours du procédé de fabrication des transistors MOS, une étape de gravure de l'isolant enterré 102 est réalisée par utilisation d'un masquage. Avantageusement, cette étape est réalisée avant la siliciuration éventuelle des source/drain et de la grille des transistors.

Enfin, comme illustré en figure 5, un isolant 112 est déposé sur les transistors 110, puis on effectue la formation des contacts des contacts (non représentés), sur la grille et sur les zones actives, dont au moins un contact 111 sur la zone conductrice 104.

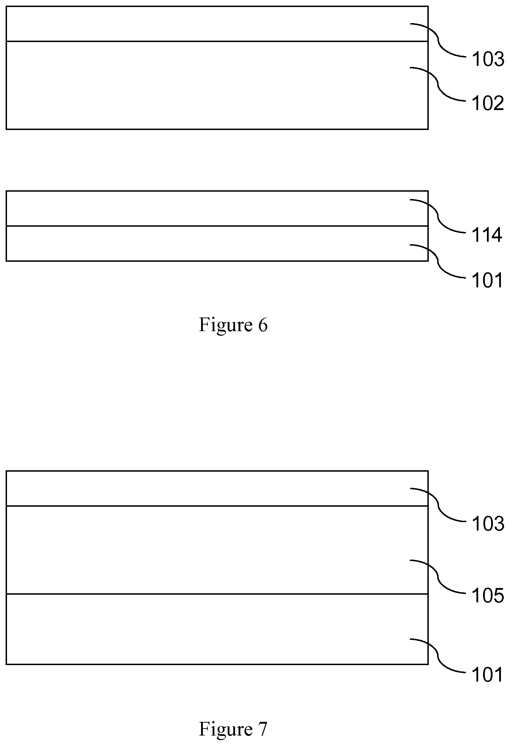

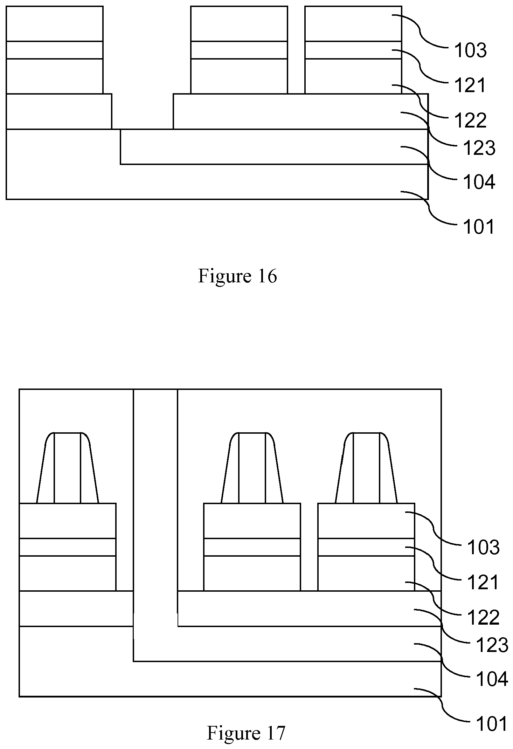

Comme on l'observe en figure 6, l'étape illustrée en figure 2 et qui concerne la réalisation d'une couche conductrice 104 peut, dans le cas d'une couche conductrice continue 114, être remplacée par une étape de collage de deux empilements. Le premier empilement comporte le substrat 101 associé à la couche conductrice 114, par exemple formée de métal ou d'un semi-conducteur dopé. Le deuxième empilement comporte au moins l'isolant 102, ou couche de piégeage, et le semi-conducteur 103. En variante, le collage concerne, d'une part, le substrat 101 et, d'autre part, le semi-conducteur 103, l'isolant 102 de piégeage et la couche conductrice 114. En variante, appliquée au cas où l'isolant 102 de piégeage est, lui-même, formé par empilement de plusieurs couches 121, 122 et 123 (voir figures 16 et 17), comme par exemple dans le cas d'une couche de piégeage en nitrure ou en poly-silicium disposée entre deux couches d'oxyde, le collage peut se faire entre deux de ces couches. Dans tous les cas, il est possible de prévoir également, entre le substrat 101 et la couche conductrice 114, une couche isolante, par exemple en SiO₂ le collage pouvant avoir lieu, ou non, au niveau de cette couche.

En variante, la couche d'isolant est formée d'un empilement de deux couches d'oxyde, une couche continue de piégeage étant formée à l'interface des deux couches d'oxyde. Ainsi, pour la formation de la première zone de piégeage, on peut procéder au collage moléculaire de deux couches d'isolant, la zone de piégeage apparaissant à l'interface de collage.

Que l'étape de réalisation d'une couche conductrice soit réalisée comme illustrée en figure 2 ou comme illustrée en figure 6, la couche d'isolant 102 de piégeage peut être un empilement de type connu dans le domaine des applications mémoires. Par exemple, comme illustré en figures 16 et 17, la couche d'isolant 102 de piégeage peut être un empilement d'une couche d'oxyde 121, d'une couche de piégeage 122 et d'une couche d'oxyde 123. Dans ce cas, l'oxyde supérieur 121 est appelé oxyde « tunnel ». L'oxyde supérieur 121 sert à l'injection des charges par effet tunnel dans la couche de piégeage 122. L'épaisseur de la couche d'oxyde tunnel 121 est de l'ordre de quelques nanomètres, typiquement 10 nm. La couche d'oxyde tunnel 121 est, typiquement, formée en SiO₂ et/ou en un matériau « High K », comme HfO₂ ou Al₂O₃. L'utilisation d'un matériau « High K » permet de réduire l'épaisseur de l'oxyde tunnel 121 et les tensions de programmation, sans trop pénaliser la rétention.

La couche de piégeage 122 sert à stocker des charges dans des pièges. Son épaisseur est de l'ordre de quelques nanomètres à quelques dizaines de nanomètres. Il peut s'agir de poly-Si, nitrure, Al₂O₃, SiO₂ sous-stoechiométrique avec des nanocristaux de Si, Ge ou de métal, ou encore d'alliage semi-conducteur/métal, réalisés par dépôt et recuit ou par implantation comme exposé dans le document US 2007 0105310. Les trois dernières options, mettant en oeuvre nitrure, Al₂O₃ ou SiO₂, avec piégeage localisé permettent de réduire l'épaisseur d'oxyde tunnel 121 par rapport au cas du poly-Si.

En variante, la formation de sites de piégeage comporte une implantation d'atomes de N (azote) ou F (fluor), qui ne créent pas de nanocristaux mais qui permettent aussi de créer ou guérir des pièges.

Ainsi, d'une manière générale, on forme des sites discrets de piégeages par exemple après implantation d'atomes de N ou F et traitement thermique et/ou en formant des nanocristaux comme exposé plus haut.

La couche d'oxyde 123 est appelé «oxyde de contrôle » ou « interpoly ». La couche d'oxyde 123 sert à assurer un couplage entre la couche de piégeage et la « grille» de contrôle qui est constituée du substrat 101 ou la couche conductrice 104 si elle existe. On note ici, qu'il est possible qu'il n'y ait pas de couche conductrice 104, si le substrat 101 est suffisamment conducteur. Dans ce cas, les transistors ne peuvent être pilotés individuellement, sauf si on utilise un pilotage par le drain (« porteur chaud »). La couche d'oxyde de contrôle 123 peut être constitué de SiO₂, de Si₃N₄ ou de Al₂O₃, ce dernier matériau étant meilleur en termes de compromis EOT/fuite (EOT est l'acronyme de « Equivalent Oxide Thickness » pour épaisseur équivalent d'oxyde) ou d'un empilement SiO₂/Al₂O₃ ou de high K/SiO₂, qui présente l'avantage d'avoir un meilleur compromis EOT/fuite.

La couche d'isolant 102 peut-être continue ou non. Elle peut être en partie discontinue si elle est constituée d'un empilement, comme dans le cinquième mode de réalisation décrit en regard des figures 16 et 17.

Pour la réalisation du deuxième mode de réalisation particulier du sous-ensemble électronique objet de la présente invention, comme illustré en figure 7, on part d'une structure SOI ou SON comportant :
- le substrat 101,
- une couche 105 d'isolant enterré, préférentiellement en SiO₂,
- le semi-conducteur supérieur, gravé ou non, 103.

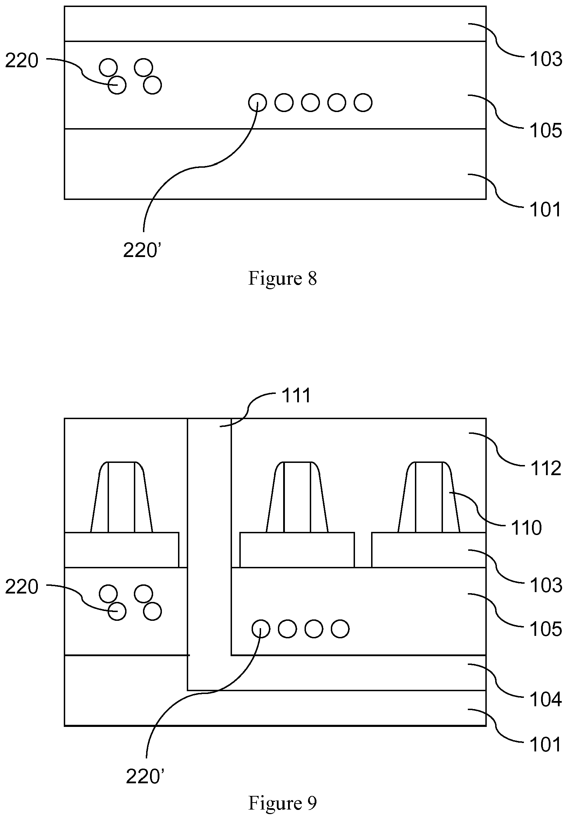

Puis, comme illustré en figure 8, on implante des atomes de Si, de Ge, de métal ou d'un alliage métal/semiconducteur dans la couche d'isolant 105, avec recuit, pour former des nano-cristaux, ou « pièges » ou « centres piégeants », 220. Dans ce cas, la couche d'isolant 105 joue le même rôle que les couches 121 et 123 cités ci-dessus et les centres piégeants 220 jouent le rôle de la couche 122. Les couches 121 et 123 peuvent ainsi être définies par les régions sans implantation de la couche d'isolant 105 et la couche 122 par la région d'implantation de centres piégeants 220. On observe que la profondeur d'implantation est contrôlée par l'énergie d'implantation. La densité des centres piégeants est contrôlée par la dose d'implantation. La répartition des centres piégeants est réalisée par un masquage.

Puis, comme illustré en figure 9, on réalise des transistors MOS 110 en surface de la couche semi-conductrice 103, de manière connue en soi, un isolant 112 est déposé sur les transistors 110 et on effectue la formation des contacts, sur grille et/ou sur les zones actives (non représentées), un contact 111 étant réalisé sur la zone conductrice 104.

Le deuxième mode de réalisation est avantageux en ce que :
- il ne nécessite pas d'autre substrat qu'un SOI ou SON standard,
- il permet de créer plusieurs régions de piégeage dans la couche d'isolant 105, avec des positions (en profondeur contrôlées par l'énergie d'implantation), ou des densités de pièges (contrôlées par la dose implantée) différentes et en effectuant successivement ou simultanément plusieurs implantations avec des profondeurs et/ou des doses et/ou des éléments différents. Ceci permet, en particulier, de modifier les tensions de seuil possibles pour une même condition d'écriture. Il est ainsi possible de définir des régions plus ou moins sensibles en écriture. Par exemple, on peut prévoir des régions où la tension de seuil peut très fortement varier (grâce à une forte densité de pièges 220 ou à des pièges 220 plus en surface) et d'autres ou la modulation de la tension de seuil est plus faible pour des conditions de polarisation données (plus faible densité de pièges 220' ou pièges 220' plus profondément implantés) et
- il permet une approche locale : un masquage peut être utilisé pour localiser les zones de piégeages 220 dans la couche d'isolant 105. En particulier, les zones de piégeages 220 peuvent être placées sous les transistors 110 dont la tension de seuil doit être changée. Plus précisément, il est possible de localiser cette implantation sous le canal seulement (et non aussi sous les source et drain), ce qui permet de réduire les courants de décharge des pièges ainsi que les capacités parasites.

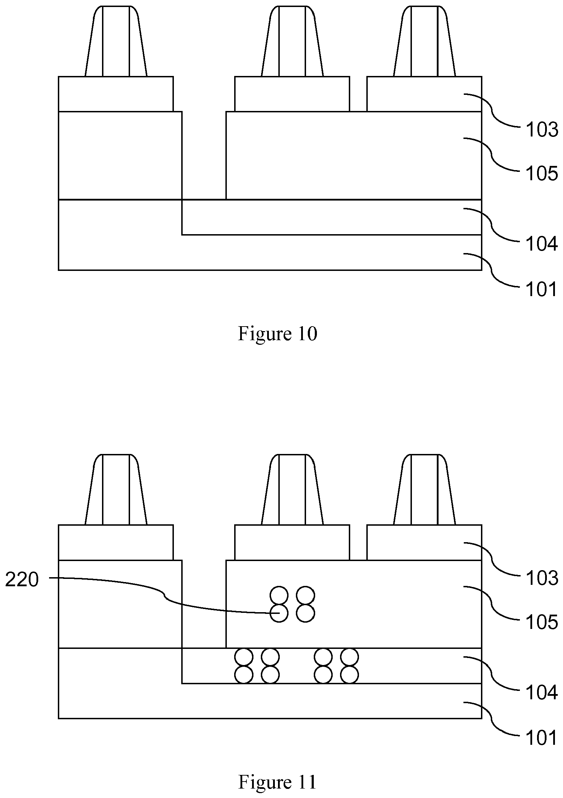

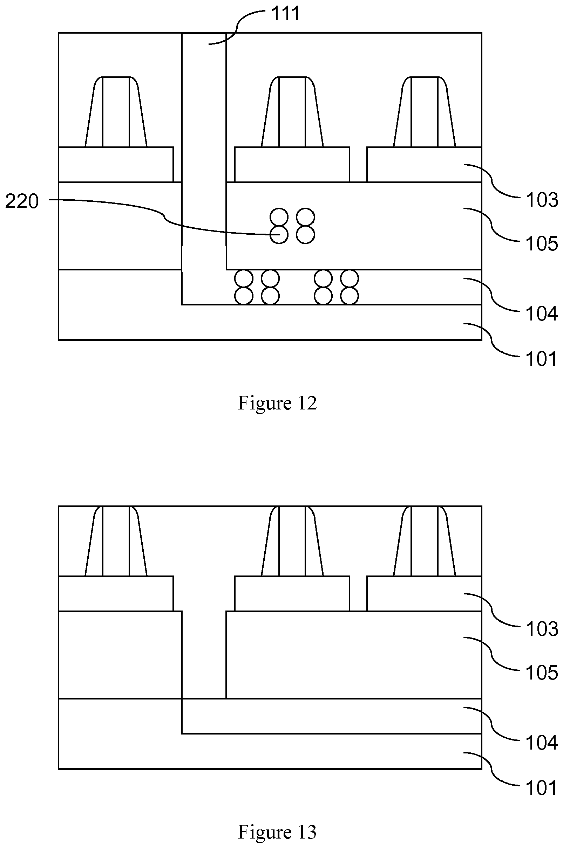

Dans le troisième mode de réalisation, décrit en regard des figures 10 à 12 et qui constitue une variante du deuxième mode de réalisation, l'implantation est réalisée à travers l'empilement de grille (« approche grille directe »). Comme illustré en figure 11, l'implantation des centres piégeants 220 est effectuée en utilisant la grille du transistor 110 comme masquage pour réaliser un auto-alignement des centres piégeants 220 sur le canal du transistor 110. L'implantation est réalisée à travers toute la structure. Etant donnée l'épaisseur supplémentaire de l'empilement au niveau de la grille, l'implantation est moins profonde au niveau de la grille que du reste de la structure. Les espèces implantées hors du canal sont donc plus en profondeur. Elles peuvent même être renvoyées, comme illustré en figures 11 et 12, dans la zone conductrice 104. La figure 12 représente la structure finale.

Dans le quatrième mode de réalisation, décrit en regard des figures 13 à 15 et qui constitue, aussi, une variante du deuxième mode de réalisation, on réalise une intégration «damascène» (ou « gate last ») des transistors 110 et on effectue les implantations dans les cavités ou à travers la grille dans une intégration «grille directe» (« gate first »).

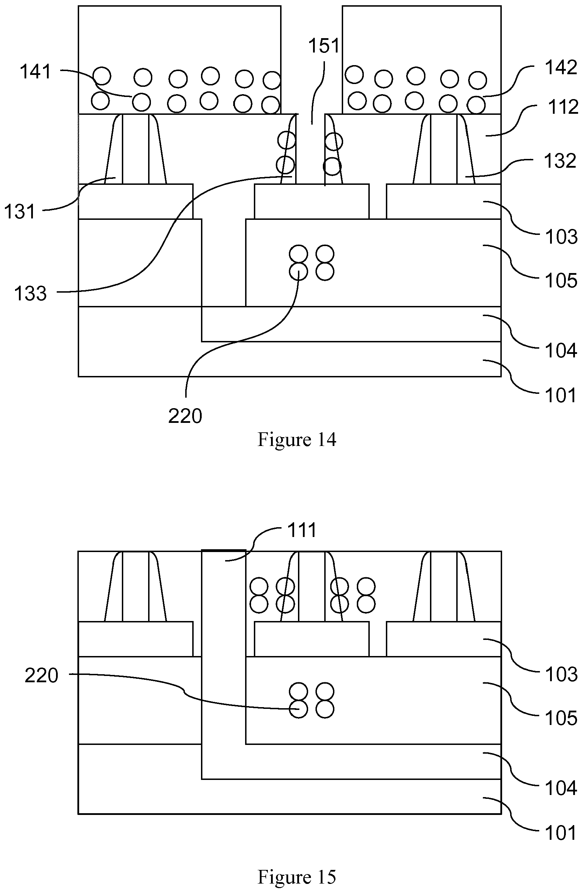

En figure 13, on retrouve la structure décrite en regard des figures 4 et 5. Puis, comme illustré en figure 14, on vide, pour certains transistors (ici, les transistors 132 et 133, à droite de la figure 14) la cavité damascène 151 au droit des futures zones de grille, en mettant en oeuvre un masquage. Le masque 141 permet, par exemple, d'éviter cette opération au niveau du transistor 131. Ce masquage sert aussi au masquage des implantations suivantes. Avantageusement, ce masquage est aligné sur les grilles des transistors 151 sous le canal desquels on souhaite positionner les atomes implantés.

Ensuite, on procède à une implantation pour former des nanocristaux 220. La structure étant plus fine au niveau des ouvertures 151, l'implantation est plus profonde au niveau de cette zone que pour le reste de la structure. Avantageusement, on peut prévoir, comme illustré au niveau du transistor 132, de réaliser l'implantation au travers d'un masque 142, pour limiter l'implantation uniquement au niveau du canal du transistor 132.

Comme illustré en figure 15, on effectue ensuite le remplissage des cavités par un empilement de grilles à base, par exemple, de poly-silicium. Les reprises de contacts sont ensuite réalisées pour former la structure finale représentée en figure 15 (tous les contacts, notamment source drain grille, ne sont pas représentés).

Les troisième et quatrième modes de réalisation sont avantageux pour ne pas créer d'éléments parasites (courant ou capacités). En effet, c'est principalement la région sous le canal qui est chargée, à cause de l'écrantage par les source/drain et qui contrôle la tension de seuil, pour la même raison. En effet, les régions de pièges placées sous les sources et les drains peuvent induire des éléments parasites : capacité parasite entre les source/drain et ces zones de pièges et courant parasite qui peuvent entraîner un déchargement des pièges, notamment pour une couche continue comme du poly-Si et, dans une moindre mesure, pour une zone de pièges discontinue.

Les troisième et quatrième modes de réalisation sont aussi avantageux car ils permettent, comme pour le deuxième mode de réalisation, d'ajuster différents transistors (ou groupes de transistors) avec une même polarisation d'écriture ou d'effacement, en procédant localement à des implantations avec des espèces et/ou des doses et/ou des énergies différentes, selon les transistors (ou groupes de transistors) permettant d'obtenir des pièges plus ou moins profonds et plus ou moins denses selon les transistors (ou groupes de transistors).

Dans le cinquième mode de réalisation particulier du sous-ensemble électronique objet de la présente invention, décrit en regard des figures 16 et 17, on met en oeuvre un empilement de couches 121, 122 et 123 décrit ci-dessus, notamment dans le cas où la couche 122 est une couche de piégeage continue, de type poly-Silicium ou nitrure. Dans ce mode de réalisation, il est préférentiel de graver au moins les couches 121 et 122 et, éventuellement, la couche 123, dans les zones d'isolation des transistors 110, lors de la formation de cette isolation pour définir des couches 122 localisées sous certains transistors 110 uniquement. Ainsi, lors de l'écriture, seuls certains transistors 110 peuvent être pilotés en tension de seuil, grâce à cette isolation.

Comme illustré en figure 16, en partant de la structure illustrée en figure 2, avec un empilement de couches 121, 122 et 123, pour former la couche d'isolant 102, on grave la couche 122 pour assurer son isolation latérale, ce qui est avantageux notamment dans le cas d'une couche continue de piégeage.

A la fin de chaque mode de réalisation d'un sous-ensemble électronique objet de la présente invention, les dernières étapes correspondent à la réalisation des transistors et aux reprises de contact comme exposé en regard du premier mode de réalisation.

La figure 17 représente ainsi la structure finale pour le cinquième mode de réalisation particulier.

On donne, ci-après une description du principe général de modification de la tension de seuil du transistor.

Pour un transistor FD sur SOI ou SON, le piégeage de charges fixes par l'isolant enterré induit un décalage de la tension de seuil du transistor par couplage capacitif. L'application de certaines polarisations permet alors l'écriture par injection de charges dans la couche d'isolant 102 ou 105, plus précisément, dans la couche 122, le cas échéant.

Une fois cette écriture faite, les charges restent dans cette couche pour une durée donnée par le temps de rétention de la structure (supérieur à 10 ans, dans le cas des empilements utilisés dans les mémoires non volatiles). Aucune polarisation n'est nécessaire pour maintenir les charges. Les polarisations d'écriture peuvent être appliquées une fois pour toute. Il est possible, en variante, à tout moment, d'effacer (ce qui entraine une diminution, voire la disparition, des charges stockées) ou de réécrire si besoin (pour modifier la quantité de charges ou rafraîchir la mémoire).

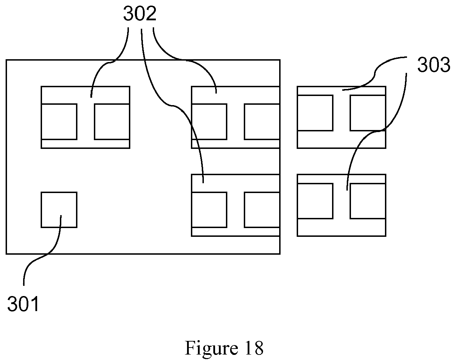

Comme illustré en figure 18, en vue de dessus, à la surface supérieur du sous-ensemble électronique se trouve une prise substrat 301, des ensembles 302 de transistors ou blocs logiques sous influence de la prise substrat 301 et des ensembles 303 de transistors ou blocs logiques qui ne sont pas sous influence de la prise substrat 301. Cette configuration permet un mode d'écriture dit en « FN » dans lequel on pilote tout ou partie du circuit par polarisation de l'électrode enterrée (ou du substrat directement s'il n'y a pas d'électrode enterrée et si le substrat est suffisamment conducteur). On pilote ainsi le Vbs du transistor, c'est-à-dire la différence de potentiel entre le substrat, ou « bulk », et la source du transistor.

Dans un deuxième mode d'écriture, dit « en porteurs chauds », seuls les transistors sélectionnés par un fort Vds, c'est-à-dire la différence de potentiel entre le drain et la source, et une forte différence de potentiel entre le substrat et la source du transistor, sont ajustés en tension de seuil. Ce mode d'écriture permet de piloter transistor par transistor avec moins de prises substrats nécessaires. Si la conductivité de la zone conductrice est parfaite, une seule prise substrat est nécessaire sur le sous-ensemble électronique, ou éventuellement, aucune prise n'est nécessaire si le substrat est suffisamment conducteur, la polarisation étant effectuée par le substrat lui-même.

Parmi les avantages de la présente invention, on peut citer :
- l'ajustement de la tension de seuil peut se faire par polarisation de la zone du substrat sous le transistor considéré (écriture en « Fowler Nordheim »),
- l'ajustement de la tension de seuil peut se faire transistor par transistor par combinaison d'une polarisation de substrat et d'une polarisation de drain (« écriture en porteurs chauds »). Dans ce cas, la prise substrat peut être partagée/mutualisée pour plusieurs transistors sans, pour autant, que cela leur affecte une certaine fonction par rapport à la valeur de la tension de seuil. Cet ajustement nécessite une prise, au moins, pour piloter la tension Vds aux bornes du transistor dont on veut ajuster la tension de seuil ou un pilotage indirecte de la tension Vds du transistor par l'intermédiaire des prises accessibles du circuit dans lequel se trouve le transistor,

- la tension de seuil peut être ajustée par l'écriture de plus ou moins de pièges enterrés, de façon quasi continue, alors que, dans le cas d'une utilisation de plusieurs travaux de sortie de grille ou de plusieurs dopages canal, seul un nombre discret d'état de tension de seuil est permis et
- la tension de seuil d'un transistor peut être reconfigurée par des polarisations (de drain et de substrat) après la fabrication des transistors. Dans le cas général de l'état de l'art, les tensions de seuil des transistors sont fixées (par le dopage canal et le travail de sortie de la grille) lors de la fabrication des transistors et ne sont pas reconfigurables par la suite et peuvent évoluer de façon incontrôlée, notamment en fonction de la température ou de l'irradiation.

Les deux derniers avantages cités ci-dessus permettent d'envisager les applications suivantes :
- allocation dynamique des paramètres de consommation/vitesse de blocs de circuiterie,
- compensation de variabilité de la tension de seuil à cause de fluctuations technologiques,
- compensation de la dérive de la tension de seuil due à un changement de température extérieure (et contrôle de la consommation),
- compensation de la dérive de la tension de seuil due à l'utilisation en milieu radiatif (et augmentation de la durée de vie des systèmes),
- circuits reconfigurables et
- réalisation de transistors MOS à tension de seuil variable.

On observe que l'information utile de chaque transistor est le transport des charges au sein de ce transistor et non, comme dans l'art antérieur, l'état de charge du transistor. On adapte ainsi la tension de seuil pour optimiser le fonctionnement du transistor en fonction de l'application du transistor, logique ou analogique.

La présente invention permet, du fait du couplage des pièges avec la grille, une application de transistor classique, dans laquelle c'est le transport de charges (c'est-à-dire le courant) qui est l'information, la tension étant un paramètre parmi d'autres de la caractéristique courant/tension du dispositif, au même titre que la mobilité des porteurs de charges, par exemple. De même, dans cette application, l'état de charge de structure n'est pas l'information principale. Ainsi, dans l'application « transistor » visée par la présente invention, l'information varie selon la fonction du transistor. En analogique ou radiofréquence (« RF »), toute une partie de la caractéristique courant/tension du transistor est utilisée et constitue l'information.

On observe qu'il est intéressant d'utiliser un oxyde enterré (ou un empilement d'oxyde enterré) fin ou à forte constante diélectrique pour diminuer la polarisation de substrat à appliquer pour charger les pièges de cet oxyde ou empilement d'oxyde. Des empilements permettant des effacements/écriture autour de 10 Volts ont été réalisés par les inventeurs.

## Revendications

1. Sous ensemble électronique pour l'utilisation d'un transport de charge au sein de transistors à tension de seuil ajustable en tant qu'information utile desdits transistor, **caractérisé en ce qu'**il comporte :
- une couche (103) de semi-conducteur portant au moins un premier et un deuxième transistors à tension de seuil ajustable, et
- une couche (102, 105) d'isolant comportant :
• à une première profondeur prédéterminée, une première zone de piégeage (220) s'étendant au moins sous le canal dudit premier transistor (110) et comportant des pièges avec une densité supérieure à la densité de pièges à l'extérieur de ladite première zone de piégeage (220),
• à une seconde profondeur prédéterminée, une deuxième zone de piégeage (220') s'étendant au moins sous le canal dudit deuxième transistor et comportant des pièges avec une densité supérieure à la densité de pièges à l'extérieur de ladite deuxième zone de piégeage (220'), la seconde zone de piégeage différent de la première zone de piégeage par :
- une deuxième profondeur différente de la première profondeur, et/ou
- une densités de pièges différente de celle de la première zone de piégeage, et/ou
- des atomes implantés différents de ceux implantés dans la première zone de piégeage,
la couche (103) de semi-conducteur et la première zone de piégeage étant en couplage capacitif et la couche (103) de semi-conducteur et la deuxième zone de piégeage étant en couplage capacitif. .

2. Sous-ensemble électronique selon la revendication 1, **caractérisé en ce que** la première zone de piégeage (220) s'étend uniquement sous le canal dudit premier transistor (110).

3. Sous-ensemble électronique selon l'une quelconque des revendications 1 ou 2, **caractérisé en ce qu'**il comporte, en outre, une zone conductrice (104) placée, par rapport à la couche d'isolant (102, 105), de l'autre côté de la couche (103) de semi-conducteur portant au moins un premier transistor (110).

4. Sous-ensemble électronique selon l'une quelconque des revendications 1 à 3, **caractérisé en ce que** les dits pièges sont constitués de nano-cristaux.

5. Sous-ensemble électronique selon la revendication 4, **caractérisé en ce que** lesdits nano-cristaux comportent des atomes de Si, de Ge, de métal ou d'alliage semiconducteur/métal dans une couche d'isolant.

6. Sous-ensemble électronique selon l'une quelconque des revendications 1 à 5, **caractérisé en ce que** les dits pièges sont formés par implantation d'atomes de N ou F et traitement thermique.

7. Procédé de réalisation d'un sous-ensemble électronique pour utilisation d'un transport de charge au sein d'un transistor à tension de seuil ajustable en tant qu'information utile dudit transistor, **caractérisé en ce qu'**il comporte :
- une étape de réalisation d'un assemblage d'une couche de semi-conducteur (103) portant au moins un premier et un deuxième transistors (110) à tension de seuil ajustable et d'une couche d'isolant (102, 105) et
- une étape de formation dans la couche d'isolant (102, 105), à une première profondeur prédéterminée, par une première implantation d'atomes, d'une première zone de piégeage (220) s'étendant au moins sous un canal dudit premier transistor (110) et comportant des pièges avec une densité supérieure à la densité de pièges à l'extérieur de ladite première zone de piégeage (220) de telle manière que la couche de semi-conducteur (103) et la première zone de piégeage soient en couplage capacitif,
- une étape de formation dans la couche d'isolant (102, 105), à une deuxième profondeur prédéterminée, par une deuxième implantation avec une énergie et/ou une dose et/ou des atomes différents de ceux utilisés lors de la première implantation, d'une deuxième zone de piégeage (220') s'étendant au moins sous un canal dudit deuxième transistor et comportant des pièges avec une densité supérieure à la densité de pièges à l'extérieur de ladite deuxième zone de piégeage (220') de telle manière que la couche de semi-conducteur (103) et la deuxième zone de piégeage soient en couplage capacitif.

8. Procédé selon la revendication 7, **caractérisé en ce que**, au cours de l'étape de formation de la première zone de piégeage, on procède au collage moléculaire de deux couches d'isolant, la zone de piégeage (220) apparaissant à l'interface de collage.

9. Procédé selon la revendication 7, **caractérisé en ce que**, au cours de l'étape de formation de la première zone de piégeage (220), on procède à une première implantation d'atomes de Ge, Si, métal ou alliage semiconducteur/métal dans la couche d'isolant (102, 105).

10. Procédé selon l'une quelconque des revendications 7 à 9, **caractérisé en ce que**, au cours de l'étape de formation de la première zone de piégeage (220), on applique un masquage pour positionner la première zone de piégeage (220).

11. Procédé selon l'une quelconque des revendications 7 à 10, **caractérisé en ce que**, au cours de l'étape de formation de la première zone de piégeage (220), on effectue un alignement grille directe, à travers l'empilement de grille, la grille de transistor étant utilisée comme masquage pour réaliser l'alignement de pièges sur le canal du transistor.

12. Procédé selon l'une quelconque des revendications 7 à 10, **caractérisé en ce que**, au cours de l'étape de formation de la première zone de piégeage, on vide une cavité damascène (151) au droit de la futur zone de grille du premier transistor en mettant en oeuvre un masquage, puis on effectue des implantations dans la cavité damascène et on remplit ensuite la cavité damascène par un nouvel empilement de grilles.

13. Procédé selon l'une quelconque des revendications 7 à 12, **caractérisé en ce qu'**il comporte une étape d'écriture en FN d'un transistor du sous-ensemble électronique.

14. Procédé selon l'une quelconque des revendications 7 à 12, **caractérisé en ce qu'**il comporte une étape d'écriture en porteurs chauds d'un transistor du sous-ensemble électronique.

15. Procédé selon l'une quelconque des revendications 7 à 14, **caractérisé en ce qu'**il comporte une étape de collage d'empilements de couches pour associer la couche de semi-conducteur, la couche d'isolant et une couche conductrice.

## Patentansprüche

1. Elektronische Teileinheit zur Verwendung eines Ladungstransports innerhalb von Transistoren mit einstellbarer Schwellenspannung als Nutzinformation der Transistoren, **dadurch gekennzeichnet, dass** sie aufweist:
- eine Halbleiterschicht (103), die mindestens einen ersten und einen zweiten Transistor mit einstellbarer Schwellenspannung trägt, und
- eine Isolatorschicht (102, 105), die aufweist:
• in einer ersten vorbestimmten Tiefe eine erste Einfangzone (220), die sich mindestens unter dem Kanal des ersten Transistors (110) erstreckt und Fallen mit einer größeren Dichte als die Fallendichte außerhalb der ersten Einfangzone (220) aufweist,
• in einer zweiten vorbestimmten Tiefe eine zweite Einfangzone (220'), die sich mindestens unter dem Kanal des zweiten Transistors erstreckt und Fallen mit einer größeren Dichte als die Fallendichte außerhalb der zweiten Einfangzone (220') aufweist, wobei die zweite Einfangzone sich von der ersten Einfangzone unterscheidet durch:
- eine zweite Tiefe anders als die erste Tiefe, und/oder
- eine andere Fallendichte als diejenige der ersten Einfangzone, und/oder
- andere implantierte Atome als diejenigen, die in die erste Einfangzone implantiert sind,
wobei die Halbleiterschicht (103) und die erste Einfangzone kapazitiv gekoppelt sind und die Halbleiterschicht (103) und die zweite Einfangzone kapazitiv gekoppelt sind.

2. Elektronische Teileinheit nach Anspruch 1, **dadurch gekennzeichnet, dass** die erste Einfangzone (220) sich nur unter dem Kanal des ersten Transistors (110) erstreckt.

3. Elektronische Teileinheit nach einem der Ansprüche 1 oder 2, **dadurch gekennzeichnet, dass** sie außerdem eine leitende Zone (104) aufweist, die bezüglich der Isolatorschicht (102, 105) auf der anderen Seite der Halbleiterschicht (103) angeordnet ist, die mindestens einen ersten Transistor (110) trägt.

4. Elektronische Teileinheit nach einem der Ansprüche 1 bis 3, **dadurch gekennzeichnet, dass** die Fallen aus Nanokristallen bestehen.

5. Elektronische Teileinheit nach Anspruch 4, **dadurch gekennzeichnet, dass** die Nanokristalle Atome von Si, von Ge, von Metall oder von einer Halbleiter/Metall-Legierung in einer Isolatorschicht aufweisen.

6. Elektronische Teileinheit nach einem der Ansprüche 1 bis 5, **dadurch gekennzeichnet, dass** die Fallen durch Implantierung von Atomen von N oder F und Wärmebehandlung gebildet werden.

7. Verfahren zur Herstellung einer elektronischen Teileinheit zur Verwendung eines Ladungstransports innerhalb eines Transistors mit einstellbarer Schwellenspannung als Nutzinformation des Transistors, **dadurch gekennzeichnet, dass** es aufweist:
- einen Schritt der Herstellung eines Zusammenbaus einer Halbleiterschicht (103), die mindestens einen ersten und einen zweiten Transistor (110) mit einstellbarer Schwellenspannung trägt, und einer Isolatorschicht (102, 105), und
- einen Schritt der Bildung in der Isolatorschicht (102, 105), in einer ersten vorbestimmten Tiefe, durch eine erste Atomimplantierung, einer ersten Einfangzone (220), die sich mindestens unter einem Kanal des ersten Transistors (110) erstreckt und Fallen mit einer größeren Dichte als die Fallendichte außerhalb der ersten Einfangzone (220) aufweist, damit die Halbleiterschicht (103) und die erste Einfangzone kapazitiv gekoppelt sind,
- einen Schritt der Bildung in der Isolatorschicht (102, 105), in einer zweiten vorbestimmten Tiefe, durch eine zweite Implantation mit einer Energie und/oder einer Dosis und/oder Atomen anders als diejenigen, die bei der ersten Implantierung verwendet werden, einer zweiten Einfangzone (220'), die sich mindestens unter einem Kanal des zweiten Transistors erstreckt und Fallen mit einer größeren Dichte als die Fallendichte außerhalb der zweiten Einfangzone (220') aufweist, damit die Halbleiterschicht (103) und die zweite Einfangzone kapazitiv gekoppelt sind.

8. Verfahren nach Anspruch 7, **dadurch gekennzeichnet, dass** während des Schritts der Bildung der ersten Einfangzone das molekulare Kleben von zwei Isolatorschichten durchgeführt wird, wobei die Einfangzone (220) an der Klebeschnittstelle auftritt.

9. Verfahren nach Anspruch 7, **dadurch gekennzeichnet, dass** während des Schritts der Bildung der ersten Einfangzone (220) eine erste Implantierung von Atomen von Ge, Si, Metall oder Halbleiter/Metall-Legierung in der Isolatorschicht (102, 105) durchgeführt wird.

10. Verfahren nach einem der Ansprüche 7 bis 9, **dadurch gekennzeichnet, dass** während des Schritts der Bildung der ersten Einfangzone (220) eine Maskierung aufgebracht wird, um die erste Einfangzone (220) zu positionieren.

11. Verfahren nach einem der Ansprüche 7 bis 10, **dadurch gekennzeichnet, dass** während des Schritts der Bildung der ersten Einfangzone (220) eine direkte Gate-Ausrichtung durch den Gate-Stapel hindurch ausgeführt wird, wobei das Transistor-Gate als Maskierung verwendet wird, um die Ausrichtung von Fallen auf den Kanal des Transistors durchzuführen.

12. Verfahren nach einem der Ansprüche 7 bis 10, **dadurch gekennzeichnet, dass** während des Schritts der Bildung der ersten Einfangzone ein Damaszener-Hohlraum (151) senkrecht vor der zukünftigen Gate-Zone des ersten Transistors geleert wird, indem eine Maskierung angewendet wird, dann Implantierungen im Damaszener-Hohlraum ausgeführt werden und anschließend der Damaszener-Hohlraum mit einem neuen Stapel von Gates gefüllt wird.

13. Verfahren nach einem der Ansprüche 7 bis 12, **dadurch gekennzeichnet, dass** es einen Schritt des Schreibens in FN eines Transistors der elektronischen Teileinheit aufweist.

14. Verfahren nach einem der Ansprüche 7 bis 12, **dadurch gekennzeichnet, dass** es einen Schritt des Schreibens in heißen Ladungsträgern eines Transistors der elektronischen Teileinheit aufweist.

15. Verfahren nach einem der Ansprüche 7 bis 14, **dadurch gekennzeichnet, dass** es einen Schritt des Klebens von Stapeln von Schichten aufweist, um die Halbleiterschicht, die Isolatorschicht und eine leitende Schicht zu verbinden.

## Claims

1. Electronic subassembly allowing charge transport within adjustable threshold-voltage transistors to be used as the useful information of said transistors, **characterized in that** it includes:
- a semiconductor layer (103) bearing at least one first and one second adjustable threshold-voltage transistor, and
- an insulating layer (102, 105) including:
• at a first preset depth, a first trapping zone (220) extending at least under the channel of said first transistor (110) and including traps with a density higher than the trap density outside of said first trapping zone (220),
• at a second preset depth, a second trapping zone (220') extending at least under the channel of said second transistor and including traps with a density higher than the trap density outside of said second trapping zone (220'), the second trapping zone differing from the first trapping zone **in that**:
- it is at a second depth different from the first depth, and/or
- it has a trap density different from that of the first trapping zone, and/or
- it contains implanted atoms that are different from those implanted into the first trapping zone,
the semiconductor layer (103) and the first trapping zone being capacitively coupled and the semiconductor layer (103) and the second trapping zone being capacitively coupled.

2. Electronic subassembly according to Claim 1, **characterized in that** the first trapping zone (220) only extends under the channel of said first transistor (110).

3. Electronic subassembly according to either one of Claims 1 and 2, **characterized in that** it furthermore includes a conductive zone (104) placed, with respect to the insulating layer (102, 105), on the other side to the semiconductor layer (103) bearing at least one first transistor (110).

4. Electronic subassembly according to any one of Claims 1 to 3, **characterized in that** said traps consist of nanocrystals.

5. Electronic subassembly according to Claim 4, **characterized in that** said nanocrystals include atoms of Si, of Ge, of metal or of metal/semiconductor alloy in an insulating layer.

6. Electronic subassembly according to any one of Claims 1 to 5, **characterized in that** said traps are formed by implantation of atoms of N or F and heat treatment.

7. Process for producing an electronic subassembly allowing charge transport within an adjustable threshold-voltage transistor to be used as the useful information of said transistor, **characterized in that** it includes:
- a step of producing an assembly of a semiconductor layer (103) bearing at least one first and one second adjustable threshold-voltage transistor (110) and an insulating layer (102, 105),
- a step of forming in the insulating layer (102, 105), at a first preset depth, via a first implantation of atoms, a first trapping zone (220) extending at least under a channel of said first transistor (110) and including traps with a density higher than the trap density outside said first trapping zone (220), in such a way that the semiconductor layer (103) and the first trapping zone are capacitively coupled, and
- a step of forming in the insulating layer (102, 105), at a second preset depth, via a second implantation with an energy and/or a dose and/or atoms different from those used in the first implantation, a second trapping zone (220') extending at least under a channel of said second transistor and including traps with a density higher than the trap density outside said second trapping zone (220'), in such a way that the semiconductor layer (103) and the second trapping zone are capacitively coupled.

8. Process according to Claim 7, **characterized in that**, in the step of forming the first trapping zone, two insulating layers are bonded by direct bonding, the trapping zone (220) appearing at the bonding interface.

9. Process according to Claim 7, **characterized in that**, in the step of forming the first trapping zone (220), a first implantation of atoms of Ge, Si, metal or semiconductor/metal alloy into the insulating layer (102, 105) is carried out.

10. Process according to any one of Claims 7 to 9, **characterized in that**, in the step of forming the first trapping zone (220), a mask is applied to position the first trapping zone (220).

11. Process according to any one of Claims 7 to 10, **characterized in that**, in the step of forming the first trapping zone (220), a gate self alignment is performed, through the gate stack, the transistor gate being used as a mask to achieve the alignment of the traps with the channel of the transistor.

12. Process according to any one of Claims 7 to 10, **characterized in that**, in the step of forming the first trapping zone, a damascene cavity (151) is emptied plumb with the future gate zone of the first transistor using a mask, then implantations are carried out into the damascene cavity and the damascene cavity is then filled with a new gate stack.

13. Process according to any one of Claims 7 to 12, **characterized in that** it includes a step of writing in an FN mode to a transistor of the electronic subassembly.

14. Process according to any one of Claims 7 to 12, **characterized in that** it includes a step of writing in a hot-carrier mode to a transistor of the electronic subassembly.

15. Process according to any one of Claims 7 to 14, **characterized in that** it includes a step of bonding stacks of layers in order to associate the semiconductor layer, the insulating layer and a conductive layer.
